# EUROPEAN PATENT APPLICATION

(11) **EP 4 601 424 A1**
(43) Date of publication of application: **13.08.2025**
(21) Application number: 24156071.3
(22) Date of filing: 06.02.2024
(51) Int. Cl.: H05K 7/14, H01L 23/00, H01R 4/30

(54) **POWER SEMICONDUCTOR MODULE ARRANGEMENT**

(71) Applicant: Infineon Technologies AG, 85579 Neubiberg (DE)
(72) Inventor: MICHALSKI, Sebastian, 13347 Berlin (DE); HERBRANDT, Alexander, 59494 Soest (DE); BÖNIG, Guido, 59581 Warstein (DE)
(74) Representative: Westphal, Mussgnug & Partner, Patentanwälte mbB

(57) **Abstract**

A power semiconductor module arrangement comprises a housing, a substrate arranged in or forming a bottom of the housing, a bus bar electrically coupled to the substrate and comprising a first end, and a second end opposite the first end, wherein the first end is electrically and mechanically coupled to the substrate, and the second end extends to the outside of the housing, and a pressing element, wherein the second end of the bus bar extends in a horizontal plane in parallel to the substrate, the second end of the bus bar comprises an opening extending therethrough in a vertical direction, wherein the vertical direction is perpendicular to the horizontal plane, the pressing element is arranged directly adjacent to a surface of the second end which faces towards the substrate, the pressing element comprises a screw nut, wherein the screw nut is aligned with the opening extending through the second end of the bus bar, and the pressing element further comprises one or more projecting sectors extending horizontally from the screw nut.

## Description

### TECHNICAL FIELD

The instant disclosure relates to a power semiconductor module arrangement, in particular to a power semiconductor module arrangement comprising a plurality of bus bars.

### BACKGROUND

Power semiconductor module arrangements often include at least one substrate (e.g., ceramic substrate) arranged in a housing. A semiconductor arrangement including a plurality of controllable semiconductor elements (e.g., IGBTs, diodes, or other semiconductor devices) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted to the substrate by soldering or sintering techniques.

Electrical lines or electrical connections are used to connect different semiconductor devices of the power semiconductor arrangement with each other. Further, terminal elements and bus bars or conductor rails are provided to contact the semiconductor arrangement from outside of the housing. Such terminal elements, bus bars and conductor rails are usually electrically coupled to the first metallization layer with a first end. A second end of the terminal elements, bus bars and conductor rails protrudes out of the housing.

There is a need for a power semiconductor module arrangement that may be produced easily and cost-effectively, that provides a high degree of flexibility, and that allows to effectively contact the second ends of bus bars or conductor rails from outside of the housing.

### SUMMARY

A power semiconductor module arrangement includes a housing, a substrate arranged in or forming a bottom of the housing, a bus bar electrically coupled to the substrate and including a first end, and a second end opposite the first end, wherein the first end is electrically and mechanically coupled to the substrate, and the second end extends to the outside of the housing, and a pressing element, wherein the second end of the bus bar extends in a horizontal plane in parallel to the substrate, the second end of the bus bar includes an opening extending therethrough in a vertical direction, wherein the vertical direction is perpendicular to the horizontal plane, the pressing element is arranged directly adjacent to a surface of the second end which faces towards the substrate, the pressing element includes a screw nut, wherein the screw nut is aligned with the opening extending through the second end of the bus bar, and the pressing element further comprises one or more projecting sectors extending horizontally from the screw nut.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a top view of a power semiconductor module arrangement.
Figure 3 schematically illustrates a top view of a power semiconductor module arrangement according to one example.
Figure 4, including Figures 4A and 4B, schematically illustrates a cross sectional view of a section of a power semiconductor module arrangement according to one example in an unconnected state (Figure 4A) and in a connected state (Figure 4B).
Figure 5, including Figures 5A and 5B, schematically illustrates a side view and a top view of a pressing element according to one example.
Figure 6, including Figures 6A and 6B, schematically illustrates a side view and a top view of a pressing element according to another example.
Figure 7 schematically illustrates a side view of a pressing element according to an even further example.
Figure 8 schematically illustrates a three-dimensional view of the pressing element of Figure 7.
Figure 9 schematically illustrates a cross-sectional view of a section of a power semiconductor module arrangement according to one example in an unconnected state.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

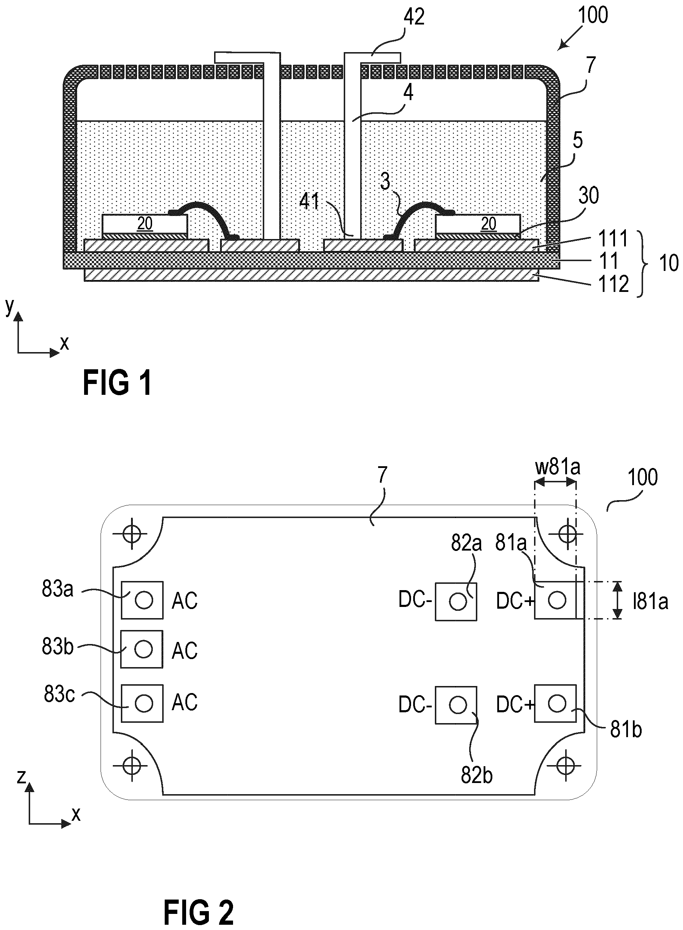

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement 100. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 may be arranged in a housing 7. In the example illustrated in Figure 1, the substrate 10 forms a ground surface of the housing 7, while the housing 7 itself solely comprises sidewalls and a cover. This is, however, only an example. It is also possible that the housing 7 further comprises a ground surface and the substrate 10 be arranged on the ground surface inside the housing 7. According to another example, the substrate 10 may be mounted on a base plate (not illustrated). In some power semiconductor module arrangements 100, more than one substrate 10 is arranged on the ground surface of a housing 7 or on a single base plate (not illustrated). A base plate may form a ground surface of the housing 7, for example.

One or more semiconductor bodies 20 may be arranged on the at least one substrate 10 (e.g., on the first metallization layer 111). Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. This, however, is only an example. Any other number of sections is possible. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer. It is further possible to omit the second metallization layer 112 altogether.

The power semiconductor module arrangement 100 illustrated in Figure 1 further includes a plurality of conductor rails or bus bars 4 (in the following only referred to as bus bars). The bus bars 4 are electrically connected to the first metallization layer 111 and provide an electrical connection between the inside and the outside of the housing 7. The bus bars 4 may be electrically connected to the first metallization layer 111 with a first end 41, while a second end 42 of the bus bars 4 protrudes out of the housing 7. The bus bars 4 may be electrically contacted from the outside at their second end 42. In the example illustrated in Figure 1, a first part of the bus bars 4 extends through the inside of the housing 7 in a vertical direction y. The vertical direction y is a direction perpendicular to a top surface of the substrate 10, wherein the top surface of the substrate 10 is a surface on which the at least one semiconductor body 20 is mounted. Instead of in the vertical direction y, the first part of a bus bar 4 which is arranged inside the housing 7 can also extend diagonally, for example. According another example, the first part of a bus bar 4 arranged inside the housing 7 can have different sections, wherein each of the different sections may extend in a vertical, diagonal or horizontal direction. The second ends 42 of the bus bars 4 that are arranged outside of the housing 7 may extend in a first horizontal direction x which is parallel to the top surface of the substrate 10, as is exemplarily illustrated in Figure 1. In this way, for some applications it may be easier to electrically contact the second ends 42. The bus bars 4 illustrated in Figure 1 are only examples. Bus bars 4 generally may be implemented in any other way and may be arranged anywhere within the housing 7. For example, one or more bus bars 4 may be arranged close to or adjacent to the sidewalls of the housing 7.

The power semiconductor module arrangement 100 may further comprise a plurality of terminal elements (not specifically illustrated in Figure 1). Terminal elements are generally configured to conduct control signals to and from the substrate 10. Control signals usually comprise electrical signals of 15V or less and are configured to control the function of the different semiconductor bodies 20. Control signals, however, may also comprise electrical signals of more than 15V. It is further necessary to provide supply voltages to the power semiconductor module arrangement 100. The power semiconductor module arrangement 100 may switch from an off state (non-working state) to an on state (working state), for example, when a supply voltage is provided. Supply voltages are generally high voltages of more than 100V, more than 300V, more than 600V and even up to several thousands of volts. The supply voltage can be between 500V and 10kV, or between 600V and 6.5kV, for example. The bus bars 4 are configured to provide such a supply voltage. Bus bars 4 may also be used to provide control signals of (significantly) more than 15V, for example.

Terminal elements that are used to conduct control signals to and from the substrate 10 are often implemented as simple pins. The bus bars 4, on the other hand, in order to be able to provide the significantly higher supply voltages and, in particular, the resulting high currents, have a larger cross-sectional area as compared to the terminal elements. According to one example, each of the plurality of bus bars 4, therefore, comprises a metal sheet.

As has been mentioned above, the power semiconductor module arrangement 100 comprises a semiconductor arrangement arranged on the substrate 10, the semiconductor arrangement comprising at least two semiconductor bodies 20. The at least two semiconductor bodies 20 may be arranged in a half-bridge configuration, for example. Any other configurations, however, are also possible. A half-bridge arrangement is generally configured to convert a DC voltage provided at an input 81, 82 of the half-bridge arrangement into an AC voltage and provided at an output 83 of the half-bridge arrangement. The AC voltage may be provided to, e.g., a load, that is coupled to the output 83 of the half-bridge arrangement. The semiconductor arrangement may be coupled between a first supply node 81 which is configured to be operatively coupled to a first electrical potential DC+ and a second supply node 82 which is configured to be operatively coupled to a second electrical potential DC-. The first electrical potential DC+ may be a positive potential and the second electrical potential DC- may be a negative potential to supply a DC voltage via the first and second supply nodes 81, 82. The first and second supply nodes 81, 82 may form the input of a half-bridge arrangement. Generally, however, the different nodes and, therefore, the different bus bars 4 may be electrically coupled to any other electrical potential instead.

One or more different bus bars 4 may be provided in order to electrically contact a semiconductor arrangement. According to one example, one bus bar 4 may be provided to form or to contact the first supply node 81, one bus bar 4 may be provided to form or to contact the second supply node 82, and one bus bar 4 may be provided to form or to contact the output node 83. For example, the second end 42 of a first bus bar 4 may form or contact the first supply node 81, the second end 42 of a second bus bar 4 may form or contact the second supply node 82, and the second end of a third bus bar 4 may form or contact the output node 83. The different bus bars 4 are electrically coupled to each other by means of the semiconductor arrangement and/or the first metallization layer 111 of the substrate 10.

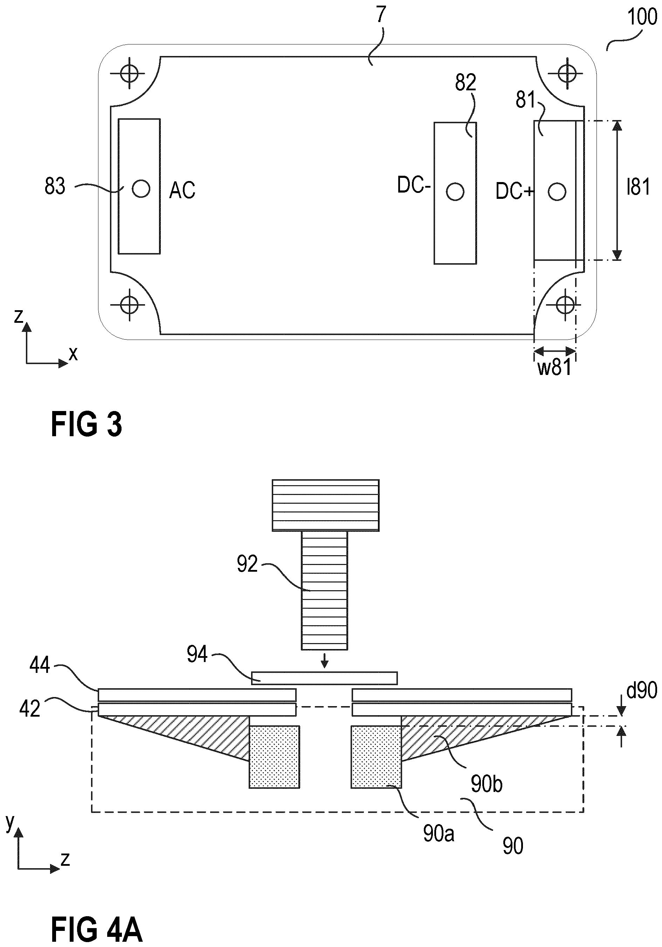

Figure 2 schematically illustrates a top view of a power semiconductor module arrangement 100 according to one example. In this top view, the housing 7 (i.e., the lid or cover of the housing 7) conceals any components arranged inside the housing 7. Therefore, the substrate 10 and any components arranged thereon are not visible in the top view of Figure 3. Figure 2, however, illustrates the second ends 42 of the plurality of bus bars 4, which protrude to the outside of the housing 7 and which form or contact the first and second supply node 81, 82 and output node 83, respectively. Each bus bar 4 may comprise a plurality of connection faces. For example, a first bus bar 4 in the example of Figure 2 which is configured to be operatively coupled to a first electrical potential DC+ comprises a first connection face (or connection flap) 81a and a second connection face (or connection flap) 81b. Similarly, a second bus bar 4 in the example of Figure 2 which is configured to be operatively coupled to a second electrical potential DC- comprises two connection faces 82a, 82b. A third bus bar 4, at which an AC voltage is provided, even comprises three connection faces 83a, 83b, 83c in the example illustrated in Figure 2.

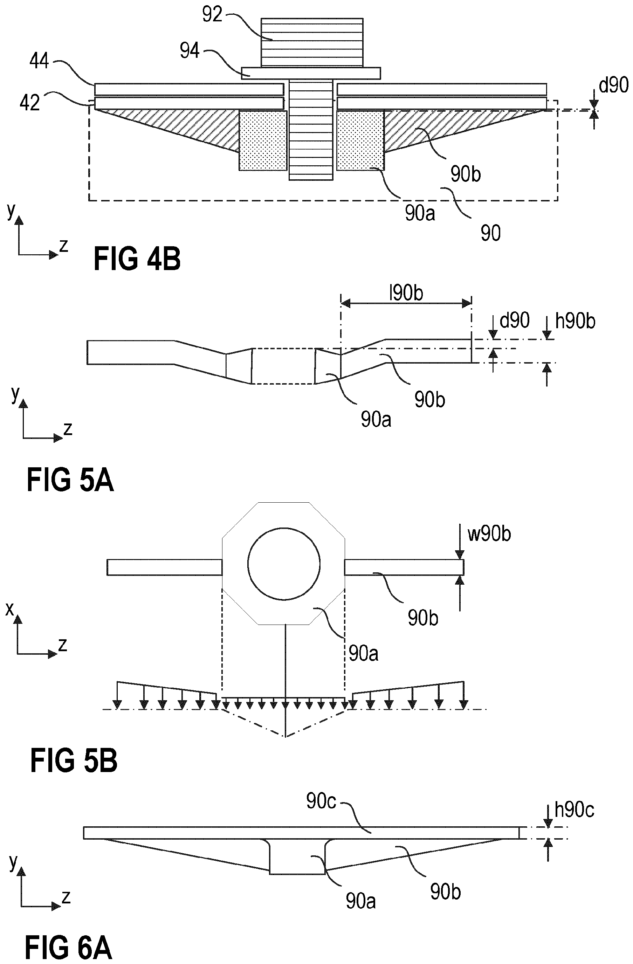

The internal bus bars 4 of a power semiconductor module arrangement 100 are usually contacted by external bus bars that may be coupled to a power or voltage source or to a load, for example. A good electrical conductivity needs to be ensured between the internal bus bars 4 of the power semiconductor module arrangement 100 and the respective external bus bars. An internal bus bar 4 and an external bus bar are often mechanically coupled to each other by means of screws. That is, a section of the internal bus bar 4, i.e. the second end 42 of an internal bus bar 4, overlaps with and is pressed against a section of the respective external bus bar, e.g., a first end 44 of an external bus bar (see, e.g., Figures 4A and 4B). The internal bus bar 4 and the corresponding external bus bar each may comprise an opening (as indicated for the internal bus bars 4 in Figure 2, for example) through which a screw may be inserted. By fastening the screw, the internal bus bar 4 (second end 42 of internal bus bar 4) and the external bus bar (e.g., first end 44 of external bus bar) may be pressed against each other in order to form a stable electrical connection. The openings in the ends 42,44 of the internal and external busbars are shown to be a round through hole in the illustrated Figures. However, it is contemplated that these holes can take other forms. For example, in addition to the illustrated round through holes, each opening could take the form of an oblong hole, an internally threaded hole, or a half hole.

The individual connection faces 81a, 81b of a bus bar 4 are usually implemented comparably small, in order to allow for a stable connection with a respective external bus bar. That is, the contact area of each individual connection face is comparably small. An overall large contact area is achieved by providing two or more separate connection faces for each of the different bus bars. For example, a width w81a and a length 181a of a connection face may each be 2cm (centimeter) or less. In this way, an external bus bar may contact each of the connection faces 81a, 81b extensively when a screw is inserted through the openings and presses the external bus bar towards the internal bus bar. However, the arrangement as schematically illustrated in Figure 2 due to the large number of connection faces 81a, 81b, 82a, 82b, 83a, 83b, 83c requires a large number of screws in order to securely contact each and every of the plurality of connection faces 81a, 81b, 82a, 82b, 83a, 83b, 83c of the different bus bars.

Now referring to Figure 3, in order to reduce the number of screws that is required to contact the internal bus bars 4, each bus bar 4, instead of two or three separate connection faces, comprises only a single connection face which, however, is lager in size as compared to the connection faces of the arrangement of Figure 2. In the example illustrated in Figure 3, a length l81 of the connection face of a first bus bar, for example, is significantly larger as compared to the length l81a of the connection faces as illustrated in Figure 2. The length l81 of the connection face may be up to 5cm, up to 8cm, or even up to 10cm, for example. In this way, the size of the contact area of the respective connection face 81, 82, 83 is significantly increased, while only requiring one screw in order to press an external bus bar on the respective connection face 81, 82, 83. A screw head, however, generally is comparably small as compared to the connection face. Therefore, when pressing two large sheets toward each other by means of a single screw, it may not be guaranteed that the large sheets (second end 42 of internal bus bar 4 and first end 44 of external bus bar) will form a stable electrical contact over their entire surface area.

A power semiconductor module arrangement 100 according to one example therefore comprises a housing 7, a substrate 10 arranged in or forming a bottom of the housing 7, and a bus bar 4 electrically coupled to the substrate 10 and comprising a first end 41, and a second end 42 opposite the first end 41, wherein the first end 41 is electrically and mechanically coupled to the substrate 10, and the second end 42 extends to the outside of the housing 7. The arrangement further comprises a pressing element 90, as is schematically illustrated, e.g., in Figures 4A and 4B. The second end 42 of the bus bar 4 extends in a horizontal plane x-z in parallel to the substrate 10, and comprises an opening extending therethrough in a vertical direction y, wherein the vertical direction y is perpendicular to the horizontal plane x-z. The pressing element 90 is arranged directly adjacent to a surface of the second end 42 which faces towards the substrate 10. The pressing element 90 comprises a screw nut 90a, wherein the screw nut 90a is aligned with the opening extending through the second end 42 of the bus bar 4, and the pressing element 90 further comprises one or more projecting sectors 90b, 90c, 90d extending horizontally from the screw nut 90a.

In Figures 4A and 4B, the components illustrated inside the dashed rectangle are parts of the power semiconductor module arrangement 100. The remaining components, i.e. the first end 44 of the external bus bar, the screw 92 and an optional washer 94, are external elements that are usually not part of the power semiconductor module arrangement 100. Such external elements are usually provided by customers, while the elements of the power semiconductor module arrangement 100 are provided and assembled by a manufacturer of the power semiconductor module arrangement 100.

The pressing element 90 may be implemented in many different ways. The general principle will be described in the following with respect to Figures 4A and 4B, wherein Figure 4A illustrates a pressing element 90 in an unconnected state and Figure 4B illustrates the pressing element 90 in a connected state. In the unconnected state in which no screw 92 is screwed into the screw nut 90a and no pressure is exerted on the second end 42 by means of the pressing element 90 (and the screw 92), the one or more projecting sectors 90b, 90c, 90d directly contact the second end 42 of the bus bar 4, and the screw nut 90a is arranged distant from the second end 42 of the bus bar 4. In a connected state in which a screw 92 is inserted through the opening extending through the second end 42 and screwed into the screw nut 90a, the one or more projecting sectors 90b, 90c, 90d are pressed towards the second end 42, and a distance d90 between the screw nut 90a and the second end 42 of the bus bar 4 is reduced as compared to the unconnected state. When a connection face of an external bus bar (e.g., first end 44 of external bus bar) is arranged between a head of the screw 92 and the second end 42 of the internal bus bar (optionally a washer 94 may be arranged between the screw head and the connection face 86 of the external bus bar), the pressing element 90 presses the second end 42 of the internal bus bar 4 on the first end 44 of the external bus bar over its entire area, or at least over a major part of its area (e.g., over more than 50% of its area, over more than 75% of its area, or over more than 90% of its area). That is, outer areas of the second end 42 of the internal bus bar 4 which are arranged the furthest from the screw 92 will also be pressed towards the first end 44 of the external bus bar, in addition to those areas that are closer to the screw 92 (i.e. area arranged directly below the head of the screw 92).

A width of the openings through the first end 44 of the external bus bar, and through the second end 42 of the internal bus bar 4 is generally smaller than a width of the head of the screw 92 or the optional washer 94. In this way, the head of the screw 92 remains vertically above the first end 44 of the external bus bar. By screwing the screw 92 into the screw head 90a arranged vertically below the first end 44 of the external bus bar and the second end 42 of the internal bus bar 4, the screw head 90a will be pulled towards the head of the screw 92, thereby pressing the second end 42 of the internal bus bar 4 on the first end 44 of the external bus bar. In the unconnected state, a distance d90 between the screw nut 90a and the second end 42 of the internal bus bar 4 may be between 0.05 and 1.0mm (millimetres), for example. This distance d90 may be reduced in the connected state, e.g., to between 0 and 0.1mm. The one or more projecting sectors 90b, 90c, 90d increase the overall contact surface of the pressing element 90, as compared to a simple screw nut without any projecting sectors.

In order to achieve this, the pressing element 90 may be somewhat springy or flexible to allow for a certain spring effect such that the screw nut 90a may move towards the second end 42 of the bus bar (i.e., towards the connection face 81) when a screw 92 is screwed into the screw nut 90a. Such a spring effect may be achieved by means of the pressing element as illustrated in Figures 5A and 5B, for example. In this example, the pressing element 90 comprises a first projecting sector 90b and a second projecting sector 90b extending radially from opposing sides of the screw nut 90a. The first and second projecting sectors 90b may be identical to each other. That is, the shape, dimensions and material of the projecting sectors 90b may be identical. Each of the first and second projecting sector 90b may have a length l90b in a second horizontal direction z, a maximum height h90b in the vertical direction y, and a width w90b in the first horizontal direction x, wherein the second horizontal direction z is perpendicular to the first horizontal direction x and the vertical direction y. The length l90b of each of the first and second projecting sectors 90b may be greater than the respective maximum height h90b, and the maximum height h90b may be greater than the respective width w90b. According to one example, the length l90b of each of the first and second projecting sectors 90b may be at least five times the respective maximum height h90b, and at least five times, or at least ten times the respective width w90b. According to one example, the width w90b of a projecting sector 90b may be between 0.8 and 3.0mm (millimetres).

That is, the projecting sectors 90b may be wing-like structures extending radially from the screw nut 90a. This is schematically illustrated in the side view of Figure 5A as well as in the top view of Figure 5B. Figure 5B further exemplarily illustrates by means of arrows a line load arising in the connected state in which the pressing element 90 is pressed towards the second end 42 of the bus bar 4. As can be seen, pressure of varying amounts is applied to the second end 42 of the internal bus bar 4 by the pressing element 90. Pressure, however, is applied over the entire length of the pressing element 90. If the length of the pressing element 90 essentially corresponds to the length l81 of the second end 42 of the internal bus bar 4, pressure will also be applied over the entire length l81 of the second end 42.

The shape of the wing-like projecting sectors 90b as illustrated in Figures 5A and 5B is only an example. Wing-like projecting sectors 90b may be implemented in any other suitable shape. For example, wing-like projecting sectors 90b may have a triangular shape, similar to what is illustrated in Figures 4A and 4B, or may have any other suitable regular or irregular shape. It is further possible that the pressing element 90 comprises even more than two wing-like projecting sectors 90b. For example, four projecting sectors 90b may be arranged evenly along a circumference of the screw nut 90a (not specifically illustrated). Additional projecting sectors 90b may have the same length or may be shorter in length l90b as compared to the projecting sectors 90b illustrated in Figures 5A and 5B. The length l90b of the individual projecting sectors 90b may depend on the dimensions of the second end 42 of the respective bus bar 4 (size of connection face).

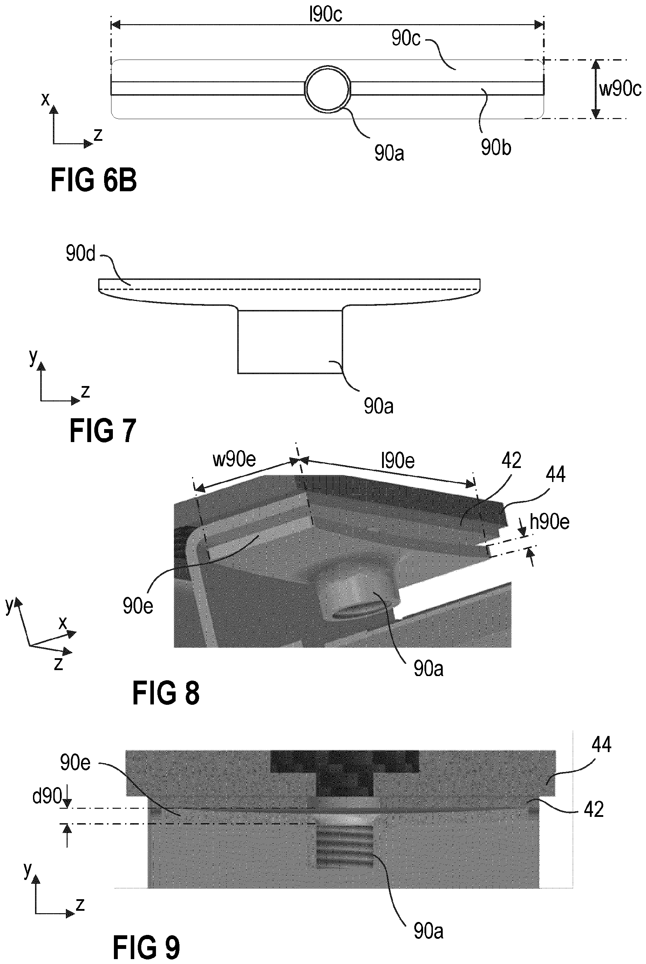

Now referring to Figures 6A and 6B, a pressing element 90 according to another example is schematically illustrated. The pressing element 90, in addition to the first and second projecting sectors 90b (or any other optional additional projecting sectors arranged radially around the circumference of the screw head 90a), further comprises a third projecting sector 90c. The third projecting sector 90c may comprise a sheet extending in a horizontal plane x-z, essentially in parallel to the substrate 10, when the pressing element 90 is arranged in its desired position in the power semiconductor module arrangement 100. The third projecting sector 90c is arranged between the second end 42 of the bus bar 4 and the first and second projecting sectors 90b in the vertical direction y. As is illustrated in Figures 6A and 6B, the third projecting sector 90c may extend from an upper rim of the screw nut 90a in a horizontal plane x-z between the first and second projecting sectors 90b and the second end 42 of the bus bar 4. An upper rim of the screw nut 90a is a rim facing towards the second end 42 of the internal bus bar 4. The third projecting sector 90c may have a length l90c in the second horizontal direction z, a width w90c in the first horizontal direction x and a height h90c in the vertical direction y, wherein the length l90c is greater than the width w90c, and the width w90c is greater than the height h90c. The third projecting sector 90c comprises a hole, the hole being aligned with the opening through the second end 42 of the bus bar 4 and with the screw nut 90a. This allows to insert a screw through the second end 42 of the internal bus bar 4 and into the screw nut 90a.

In the example illustrated in Figures 6A and 6B, the third projecting sector 90c is essentially flat. This, however, is only an example. Now referring to Figures 7, 8 and 9, pressing elements 90 according to even further examples are schematically illustrated. In these examples, the pressing element 90 comprises a curved projecting sector 90d, 90e extending from an upper rim of the screw nut 90a. The curved projecting sector 90d has a length l90e in the second horizontal direction z, a width w90e in the first horizontal direction x and a height h90e in the vertical direction y, wherein the length l90e is greater than the width w90e, and the width w90e is greater than the height h90e. That is, the curved projecting sector 90d, 90e may have an essentially rectangular shape, and may be formed by a (metal) sheet. The curved projecting sector 90d, 90e comprises a hole, the hole being aligned with the opening through the second end 42 of the bus bar 4 and with the screw nut 90a. The hole may be arranged centrally within the curved projecting sector 90d, 90e.

The curved projecting sector 90e may be curved in one direction in space only, as is schematically illustrated in Figures 8 and 9, for example. For example, the curved projecting sector 90e may be curved along its length l90e. The curved projecting sector 90e may have a concave shape towards the second end 42 of the bus bar 4. That is, in the unconnected state in which no screw is screwed into the screw nut 90a, only the two outer ends of the curved projecting sector 90e directly contact the second end 42 of the bus bar 4, while any other sections of the curved projecting sector 90e are curved away from the second end 42. This is schematically illustrated, e.g., in the cross-sectional view of Figure 9. As the curved projecting sector 90e is comparably thin (e.g., height h90e between 0.8 and 2.00 mm), it is flexible to a certain degree. The pressing element 90 in this example does not comprise the first and second projecting sectors 90b. When a screw is screwed into the screw nut 90a, with the second end 42 of an internal bus bar 4 and a first end 44 of an external bus bar arranged between the head of the screw and the screw nut 90a, the screw nut 90a moves towards the second end 42 of the internal bus bar 4 in the vertical direction. That is, the curvature of the curved projecting sector 90e is reduced in the connected state, as compared to the unconnected state. In this way, the contact area between the pressing element 90 (i.e., the curved projecting sector 90e) and the second end 42 of the internal bus bar 4 in the connected state is larger as compared to the unconnected state. In some examples, the entire surface of the curved projecting sector 90e may contact the second end 42 of the internal bus bar 4 in the connected state (curved projecting sector 90e is essentially flat in the connected state). It is, however, also possible that not the entire surface of the curved projecting sector 90e contacts the second end 42 of the internal bus bar 4 in the connected state. However, according to examples, at least 70% or at least 90% of the surface of the curved projecting sector 90e may contact the second end 42 of the internal bus bar 4 in the connected state. In the unconnected state, less than 20% or even less than 10% of the surface of the curved projecting sector 90e may contact the second end 42 of the internal bus bar 4.

Now referring to Figure 7, according to other examples, the curved projecting sector 90d may be curved in two directions in space, e.g., along its length l90e as well as along its width w90e. That is, the curved projecting sector 90d may have the shape of a flat bowl or plate, for example. The general principle, however, is similar to what has been described in respect to Figures 8 and 9 above. In the example illustrated in Figure 7, the curved projecting sector 90d may contact the second end 42 of the internal bus bar 4 along its entire circumference, while central parts of the curved projecting sector 90d are curved away from the second end 42. In the connected state, the screw nut 90a moves towards the second end 42 of the internal bus bar 4, and the contact area between the curved projecting sector 90d and the second end will be increased as compared to the unconnected state.

The curved projecting sector 90d, 90e may be formed integrally with the screw nut 90a. That is, the entire pressing element 90 may be formed as a single piece. It is, however, also possible, that the screw nut 90a and the curved projecting sector 90d, 90e are separate elements. The screw nut 90a and the curved projecting sector 90d, 90e may be permanently coupled to each other in suitable ways (e.g., welding). It is, however, also possible that there is no permanent connection formed between the screw nut 90a and the curved projecting sector 90d, 90e. According to one example, the curved projecting sector 90d, 90e comprises a rim or sleeve extending vertically from a circumference of the hole formed in the curved projecting sector 90d, 90e. This rim or sleeve may protrude into the screw nut 90a when the screw nut 90a and curved projecting sector 90d, 90e are assembled to form the pressing element 90. The curved projecting element 90d, 90e is prevented from moving horizontally with respect to the screw nut 90a when the rim or sleeve extends into the screw nut 90a. A vertical movement is prevented by the screw nut 90a arranged on one side, and the second end 42 of the internal bus bar 4 arranged on the other side of the pressing element 90.

A pressing element 90 according to any of the examples that have been described above may be easily inserted into the power semiconductor module 100. For example, the housing 7 may comprise corresponding recesses into which the pressing element 90 may be inserted. When the pressing element 90 is inserted into a define recess formed in the housing 7, it may be prevented from rotating when screwing a screw into the screw nut 90a.

## Claims

1. A power semiconductor module arrangement (100) comprises:
a housing (7);
a substrate (10) arranged in or forming a bottom of the housing (7);
a bus bar (4) electrically coupled to the substrate (10) and comprising a first end (41), and a second end (42) opposite the first end (41), wherein the first end (41) is electrically and mechanically coupled to the substrate (10), and the second end (42) extends to the outside of the housing (7); and
a pressing element (90), wherein
the second end (42) of the bus bar (4) extends in a horizontal plane (x-z) in parallel to the substrate (10),
the second end (42) of the bus bar (4) comprises an opening extending therethrough in a vertical direction (y), wherein the vertical direction (y) is perpendicular to the horizontal plane (x-z),
the pressing element (90) is arranged directly adjacent to a surface of the second end (42) which faces towards the substrate (10),
the pressing element (90) comprises a screw nut (90a), wherein the screw nut (90a) is aligned with the opening extending through the second end (42) of the bus bar (4), and
the pressing element (90) further comprises one or more projecting sectors (90b, 90c, 90d) extending horizontally from the screw nut (90a).

2. The power semiconductor module arrangement (100) of claim 1, wherein
in an unconnected state in which no screw (92) is screwed into the screw nut (90a), the one or more projecting sectors (90b, 90c, 90d) directly contact the second end (42) of the bus bar (4), and the screw nut (90a) is arranged distant from the second end (42) of the bus bar (4), and
in a connected state in which a screw (92) is inserted through the opening extending through the second end (42) and screwed into the screw nut (90a), the one or more projecting sectors (90b, 90c, 90d) are pressed towards the second end (42), and a distance (d90) between the screw nut (90a) and the second end (42) of the bus bar (4) is reduced as compared to the unconnected state.

3. The power semiconductor module arrangement (100) of claim 2, wherein, in the unconnected state, the distance (d90) between the screw nut (90a) and the second end (42) of the bus bar (4) is between 0.05 and 1.0mm.

4. The power semiconductor module arrangement (100) of claim 2 or 3, wherein, in the connected state, the distance (d90) between the screw nut (90a) and the second end (42) of the bus bar (4) is between 0 and 0.1mm.

5. The power semiconductor module arrangement (100) of any of claims 1 to 4, wherein
the pressing element (90) comprises a first projecting sector (90b) and a second projecting sector (90b) extending radially from opposing sides of the screw nut (90a).

6. The power semiconductor module arrangement (100) of claim 5, wherein
each of the first and second projecting sector (90b) has a length (190b) in a second horizontal direction (z), a maximum height (h90b) in the vertical direction (y), and a width (w90b) in the first horizontal direction (x), wherein the second horizontal direction (z) is perpendicular to the first horizontal direction (x) and the vertical direction (y), and
the length (190b) of each of the first and second projecting sectors (90b) is greater than the respective maximum height (h90b), and the maximum height (h90b) is greater than the respective width (w90b).

7. The power semiconductor module arrangement (100) of claim 6, wherein the width (w90b) of a projecting sector (90b) is between 0.8 and 3.0mm.

8. The power semiconductor module arrangement (100) of claim 5, 6 or 7, further comprising a third projecting sector (90c) extending from an upper rim of the screw nut (90a) in a horizontal plane (x-z) between the first and second projecting sectors (90b) and the second end (42) of the bus bar (4), wherein
the third projecting sector (90c) has a length (l90c) in the second horizontal direction (z), a width (w90c) in the first horizontal direction (x) and a height (h90c) in the vertical direction (y), wherein the length (190c) is greater than the width (w90c), and the width (w90c) is greater than the height (h90c), and
the third projecting sector (90c) comprises a hole, the hole being aligned with the opening through the second end (42) of the bus bar (4) and with the screw nut (90a).

9. The power semiconductor module arrangement (100) of any of claims 1 to 4, wherein the pressing element (90) comprises a curved projecting sector (90d, 90e) extending from an upper rim of the screw nut (90a), wherein
the curved projecting sector (90d, 90e) has a length (l90e) in the second horizontal direction (z), a width (w90e) in the first horizontal direction (x) and a height (h90e) in the vertical direction (y), wherein the length (l90e) is greater than the width (w90e), and the width (w90e) is greater than the height (h90e), and
the curved projecting sector (90d, 90e) comprises a hole, the hole being aligned with the opening through the second end (42) of the bus bar (4) and with the screw nut (90a).

10. The power semiconductor module arrangement (100) of claim 9, wherein the curved projecting sector (90e) is curved in one direction in space along its length (l90e).

11. The power semiconductor module arrangement (100) of claim 9, wherein the curved projecting sector (90e) is curved in two directions in space along its length (l90e) and along its width (w90e).

12. The power semiconductor module arrangement (100) of any of claims 9 to 11, wherein the curved projecting sector (90d, 90e) is formed integrally with the screw nut (90a).
